# EUROPÄISCHE PATENTSCHRIFT

(11) **EP 2 308 086 B1**
(45) Veröffentlichungstag und Bekanntmachung des Hinweises auf die Patenterteilung: **15.01.2014**
(21) Anmeldenummer: 09780381.1
(22) Anmeldetag: 09.07.2009
(51) Int. Cl.: H01L 31/048, H01L 31/0392, H01L 31/068

(54) **Solarpanel**
Solar panel
Panneau solaire

(30) Priorität: 15.07.2008 DE 102008033217
(43) Veröffentlichungstag der Anmeldung: 13.04.2011
(73) Patentinhaber: Dritte Patentportfolio Beteiligungsgesellschaft mbH & Co. KG, 12529 Schönefeld / Waltersdorf (DE)
(72) Erfinder: HAUSER, Otto, 73732 Esslingen (DE); FREY, Hartmut, 73732 Esslingen (DE)
(74) Vertreter: Zech, Stefan Markus
(86) Internationale Anmeldenummer: PCT/EP2009/058757
(87) Internationale Veröffentlichungsnummer: WO 2010/006988

(56) Entgegenhaltungen:
- DE-A1-102006 023 638
- GB-A- 2 255 227
- US-A- 3 255 047
- US-A- 3 411 050
- US-A1- 2004 187 917
- US-A1- 2005 056 312
- US-A1- 2005 150 542
- US-A1- 2007 295 385
- US-B2- 7 126 053
- DATABASE WPI Week 200648 Thomson Scientific, London, GB; AN 2006-467090 XP002544989 & JP 2006 165149 A (CANON KK) 22. Juni 2006 (2006-06-22) -& JP 2006 165149 A (CANON KK) 22. Juni 2006 (2006-06-22)

## Beschreibung

Ein Solarpanel besteht aus einem Substrat, das gleichzeitig mechanischer Träger ist für die darauf aufgebrachten Halbleiterschichten. Die Halbleiterschichten erzeugen eine flächige Sperrschicht, an der bei Beleuchtung freie Elektronen produziert werden. Diese freien Elektronen können bei äußerer Beschaltung des Solarpanels einen Gleichstrom erzeugen.

Das Substrat das den mechanischen Träger bildet, ist bei den bekannten solarzellen lichtundurchlässig.

US 7126053 offenbart ein Solarpanel mit zwei p-n Übergängen.

Ausgehend hiervon ist es Aufgabe der Erfindung eine Solarzelle/Solarpanel zu schaffen, das sich durch einen verbesserten Wirkungsgrad auszeichnet.

Diese Aufgabe wurde erfindungsgemäß mit einem Solarpanel oder einer Solarzelle mit dem Merkmal des Anspruches 1 gelöst.

Bei der erfindungsgemäßen Solarzelle, besteht das mechanisch feste Substrat aus einem lichtdurchlässigen und elektrisch leitenden Material. Auf jeder der Flachseiten des Substrates ist jeweils ein Paar aus Halbleiterschichten aufgebracht. Die beiden Halbleiterschichten aus jedem Paar von Halbleiterschichten, die unmittelbar dem Substrat benachbart sind, sind vom selben Leitungstyp. An der Grenzschicht zwischen den Halbleiterschichten jedes Paares wird eine Sperrschicht erzeugt, die bei Bestrahlung mit Licht Elektronen abgibt.

Das Substrat ist als Gestrick, Gewirk oder Gewebe ausgeführt.

Da das Substrat lichtdurchlässig ist, können Photonen, die beim Auftreffen auf die erste Sperrschicht, nicht absorbiert wurden, durch den lichtdurchlässigen Träger in die zweite Sperrschicht eintreten und dort gegebenenfalls wiederum zur Erzeugung freier Elektronen herangezogen werden.

Bei der erfindungsgemäßen Solarzelle stehen somit beiciseits des Substrates oder Trägers zwei Sperrschichten zur Verfügung, was den Wirkungsgrad deutlich erhöht.

Das Substrat kann ein Gitter oder gitterähnliche Struktur aufweisen.

Das Substrat kann von einem textilen Flachengebilde gebildet sein, mit der Folge, dass das Substrat sehr leicht und biegsam und damit weniger bruchempfindlich ist, obwohl es sehr dünn ist.

Im Falle eines Substrates auf einem textilen Flächengebildet kann dieses eine Mischung aus lichtdurchlässigen Fäden und lichtundurchlässigen elektrisch leitenden Fasern oder Fäden enthalten.

Im Falle der lichtdurahlässigen Fäden, sind diese vorzugsweise Fäden aus Glasfasern.

Die Fäden aus elektrisch leitendem Material können metallische Fäden oder Kohlefaserfäden sein.

Aufgrund der Verbindung zwischen lichtdurchlässigen und elektrisch leitenden Fäden bzw. Fasern wird erreicht, dass aus der Sperrschicht, gebildet durch den Träger oder das Substrat, die Elektronen abfließen können. Der Träger bzw. Substrat wirken insoweit als Elektrode, wobei die lichtdurchlässigen Fäden zwischen den überwiegend lichtundurchlässige Fäden für die erforderlichen "Löcher" sorgen durch, die Licht auf die hintere, d.h. der der Lichtquelle entfernte Sperrschicht, durchlassen.

In jedem Fall ist das erhaltene Substrat sehr flexibel, vergleichsweise extrem leicht und dünn.

Das Substrat bzw. der Träger liegen in Gestalt eines Gewebes, eines Gestricks oder eines Gewirkes vor. Im Fall eines Gewebes in Leinwand- oder Köperbindung bestehen die Schussfäden aus Glasfaserfäden und die Kettfeden aus Kohlefaserfäden. Die umgekehrte Anordnung ist ebenfalls denkbar, bei der das Material für die Kette und die Schussfäden miteinander vertauscht sind, je nach dem was sich leichter weben lässt.

Im Falle eines Gestrickes oder Gewirkes können die Maschenreihen abwechselnd aus Glasfaserfäden oder aus Kohlefaserfäden bestehen.

Auf der jeweils äußeren Halbleiterschicht kann eine lichtdurchlässig elektrisch leitende Schicht aufgebracht werden, die vorzugsweise aus ZnO besteht.

Zur Kontaktierung kann ein Aluminiumgitter verwendet werden, das beispielsweise mit Hilfe eines Tampondruckverfahrens aufgebracht wird.

Um den Wirkungsgrad zu verbessern, ist wenigstens eine Außenfläche mit einer Antireflexschicht versehen.

Die Kratzempfindlichkeit wird verbessert, wenn die Außenschicht eine C-Schicht in Diamantstruktur ist.

Die nachfolgende Figurenbeschreibung erläutert Aspekte zum Verständnis der Erfindung. Weitere nicht beschriebene Details kann der Fachmann in gewohnter Weise der Zeichnung entnehmen, die insoweit die Figurenbeschreibung ergänzt. Es ist klar, dass eine Reihe von Abwandlungen möglich sind, die genaue Dimensionierung kann der Fachmann ohne Weiteres empirisch auf Grund der angegebenen Daten vornehmen.

Die nachfolgende Figuren sind nicht maßstäbliche zur Veranschaulichung von Details sind bestimmte Bereiche übertrieben groß dargestellt. Darüber hinaus sind die Figuren plakativ vereinfacht und enthalten nicht jedes bei der praktischen Ausführung gegebenenfalls vorhandene Detail.

In der Zeichnung ist ein Ausführungsbeispiel des Gegenstandes der Erfindung dargestellt.
- Fig. 1: zeigt einen Längsschnitt durch einen Ausschnitt der erfindungsgemäßen Solarzelle.
- Fig. 2: zeigt eine perspektivische Ansicht eines Gestrickes, wie es als Substrat für das erfindungsgemäße Solarelement verwendbar ist.

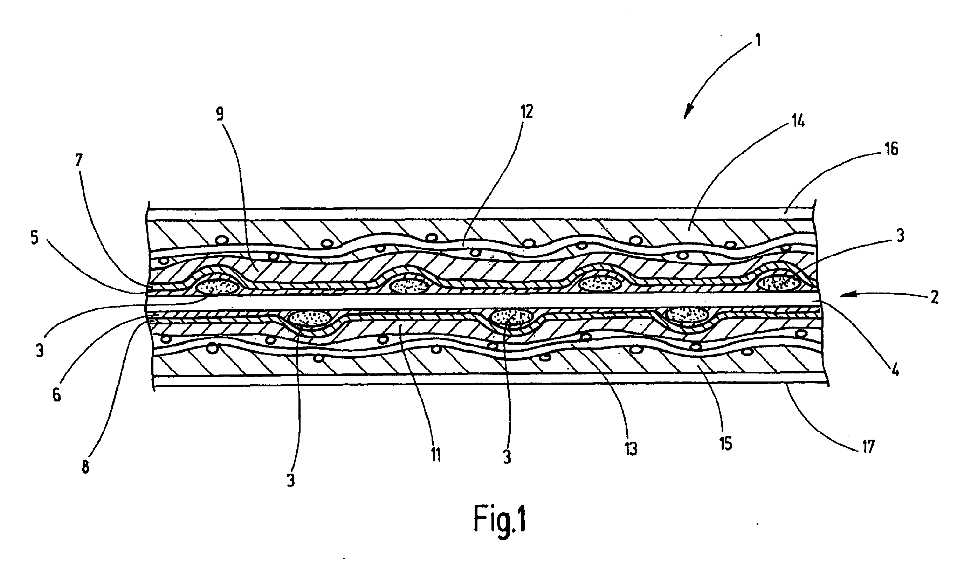

Fig. 1 zeigt einen stark schematisierten, plakativ vereinfachten Schnitt durch eine Solarzelle 1. Zu der Solarzelle 1 gehört ein Substrat 2, in Form eines Gewebes in Leinwand- oder Köperbindung. Das das Substrat 2 bildende Gewebe weist Kettfäden 3 sowie Schussfäden 4 auf. Diese Art von Gewebe ist aus der Textiltechnik bekannt und braucht jemals nicht weiter beschrieben oder dargestellt zu werden. Die Kettfäden 3 bestehen, wie auf der linken Seite angedeutet ist, aus einer Vielzahl von parallel nebeneinander liegenden und gegebenfalls auch miteinander verzwirnten Glasfasermonofilamenten. Sie sind damit lichtdurchlässig, jedoch an sich nicht elektrisch leitend.

Die Schussfäden 4 hingegen bestehen aus Kohlefasern und sind damit elektrisch leitend.

Es versteht sich, dass Kett- und Schussfäden auch die Plätze tauschen können, das heißt, die mit 4 bezeichneten Fäden können auch Kettfäden sein, womit dann die mit 3 bezeichneten Fäden Schussfäden wären. Für die weitere Betrachtung ist dies gleichgültig.

Auf dem so gebildeten Substrat 2 in Form eines textilen Flächengebildes befindet sich, bezogen auf die Figur 1, auf der Oberseite, eine p-dotierte Si-Schicht 5. Eine weitere p-dotierte Si-Schicht 6 ist auf der Unterseite des Substrates 2 aufgebracht- Auf der von dem Substrat 2 abliegenden Fläche der Si-Schicht 5 befindet sich eine n-dotierte Si-Schicht 7 und eine weitere n-dotierte Si-Schicht 8 ist auf der SI-Schicht 6 auf der von dem Substrat 2 abliegenden Seite vorhanden.

Die Si-Schichten 5 und 7 bilden einen Halbleiter-pn-Übergang ebenso wie die beiden Schichten 6 und 7 an ihrer Kontaktfläche. Diese Sperrschicht ist der eigentliche aktive Teil der Solarzelle 1.

Auf der freien, das heißt, von dem Substrat 2 weg zeigenden Seite der Si-Schicht 7 ist eine elektrisch gut leitende Schicht 9, beispielsweise aus ZnO aufgebracht. Diese Zinkoxid-Schicht dient der Verringerung des Innenwiederstands. Eine entsprechende zinkoxid-Schicht 11 befindet sich auf der Si-Schicht 8, und zwar auf der der Si-Schicht gegenüberliegenden Seite.

Zwecks Kontaktierung der beiden Zno-Schichten 9 und 11 sind zwei Aluminiumgitterstrukturen 12 und 13 vorhanden, die in Figur 1 symbolhaft als Drahtgitter gezeigt sind. Diese Gitterstrukturen 12 und 13 stellen Elektroden zum Kontaktieren der Si-Schichten 7 und 8 dar.

Die Gitterstrukturen 12 und 13 sind lediglich zwecks Erkennbarkeit mit dem Querschnitt wie gezeigt dargestellt. Tatsächlich handelt es sich bei den Gittern um Gitterstrukturen, die im Tampondruckverfahren aufgedruckt sind. Eine solche Struktur wäre in der Darstellung nicht erkenntlich; die gewählte Drahtstruktur ist hier stellvertretend gezeigt. Das Aufbringen derartiger Gitterstrukturen ist aus dem Stand der Technik hinreichend bekannt.

Damit möglichst wenig auftreffendes Licht reflektiert wird, befindet sich auf der Außenseite der ZnO-Schicht 9, beziehungsweise der Außenseite derZnO-Schioht 11 jeweils eine Antireflexschicht 14 und 15 aus Si₃N₄. Schließlich ist auf den Außenseiten der jeweiligen Antireflexschicht 14 und 15 noch jeweils eine Schutzschicht 16 und 17 als mechanischer Schutz aufgebracht. Bei den Schichten 16 und 17 handelt es sich um Kohlenstoffschichten mit Diamantstruktur. Derartige Schichten werden im CVD-Verfahren (Chemical Vapor Disposition) erzeugt.

Die Si-Schichten 5,6,7 und 8 können ebenfalls im CVD-Verfahren erzeugt werden oder in einer Art und Weise, wie dies in der DE 10 2007 50 288 ausführlich beschrieben ist.

Zwecks Kontaktierung der so erzeugt, flächigen Siliziumfotodioden ist die Gitterstruktur 12 bzw. 13 an dem Rand der Solarzelle mit entsprechenden Kupferleitern verbunden. Hierzu stehen die Gitterstrukturen 12, 13 entsprechend lang an der Seitenkante bzw. den Rändern der Solarzelle 1 vor.

Die zweite Elektrode bilden die aus Kohlefasern bestehenden Fäden 4, die aufgrund der Gewebebindung parallel nebeneinander verlaufen. Die Kohlefasern stehen ebenfalls seitlich aus der Solarzelle 1 vor und sind in geeigneter Weise mit einer Metallschicht am überstehenden Ende versehen, um hier eine gute Kontaktierung zu metallischen Leitern zu erzeugen.

Die Funktionsweise der beschriebenen Solarzelle 1 ist wie folgt:
Wenn beispielsweise bezogen auf Figur 1 von oben kommend Licht auf die Solarzelle 1 fällt, gelangt dieses Licht durch die Schutzschicht 16, die Antireflexschicht 14, die Gitterstruktur 12 und die Kontaktierungsschicht 9 in die zwischen den beiden Si-Schicht 5 und 7 gebildete sperrSchicht. Die eintreffenden Photonen erzeugen Elektronen, die über die Elektroden 4 und 12 zu einem Verbraucher abfließen können und nach dem Fließen durch den Verbraucher zu der anderen Seite der Sperrschicht zurückgelangen.

Da nicht sämtliche Photonen des einfallenden Lichtes freie Elektronen erzeugen, sondern ungestört die Sperrschicht zwischen den Si-Schichten 5 und 7 passieren, gelangen sie durch die Gitterstruktur des Substrates 2 in die Sperrschicht zwischen den Si-Schichten 6 und 8. In der oberen Sperrschicht nicht verbrauchten Photonen können somit in der zweiten Sperrschicht ebenfalls zur Erzeugung von freien Elektronen herangezogen werden.

Aufgrund der Funktionsangabe ist der Fachmann in der Lage die Bemessung des Substrates 2 vorzunehmen. Es muss ein für die jeweilige Anwendung günstige Kompromiss geschlossen werden zwischen der Anzahl der leitenden Kohlefasern 4 und den nicht leitenden jedoch lichtdurchlässigen Glasfäden 3. Wenn der Abstand zwischen den Kohlefaserfäden 4 zu groß wird, steigt der Innenwiderstand der Solarzelle 1 an. Wenn hingegen der Abstand zu klein gewählt wird, wird die von der Lichtquelle abliegende und insoweit auf der Rückseite des Substrates 2 liegende Sperrschicht zu wenig beleuchtet.

Wie sich aus der Funktionsbeschreibung ebenfalls ergibt, wirken die Glasfaserfäden 3, die mit den Kohlefaserfäden 4 verwoben sind, als Abstandshalter für die Kohlefaserfäden. Es entsteht ein flexibles Substrat, das einerseits lichtdurchlässig ist, andererseits elektrisch leitend ist und genügend fest ist, damit bei der mechanischen Beanspruchung des Substrates, die aufgebrachten Schichten nicht soweit beschädigt werden können, dass die Solarzelle funktionsunfähig wird. Brüche und Risse in den So-Schichten 5...8 beeinträchtigen letztlich die Funktionsfähigkeit der Selarzelle 1 nicht, da die durch die Brüche entstandene Inseln über die Elektroden in Gestalt der Gitterstruktur 12, 13 sowie der Kohlefaserfäden 4 elektrisch untereinander parallel geschaltet sind.

Die Struktur ist in Figur 1 bezüglich des Substrates 2 symmetrisch dargestellt. Es versteht sich jedoch, dass auch in der Rückseite beispielsweise die Antireflexschicht 15 entfallen kann.

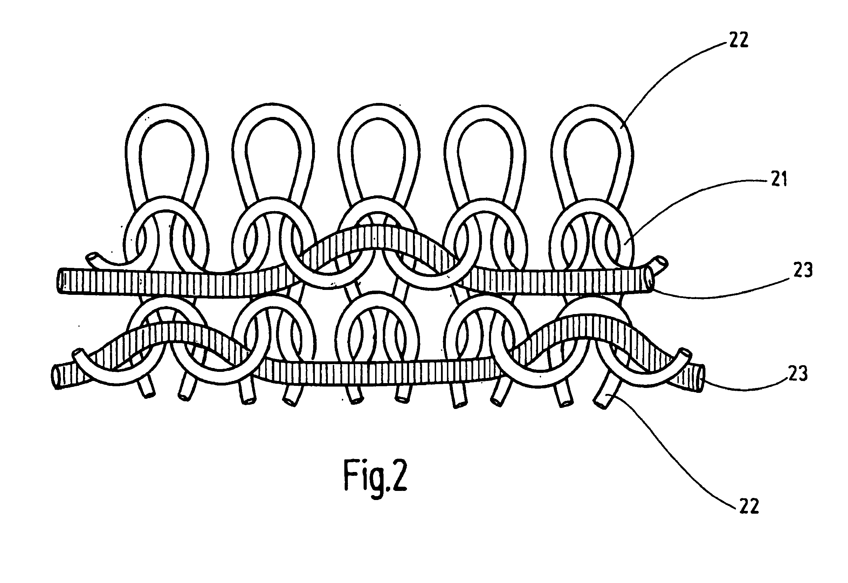

Als Substrat 2, eignet sich nicht nur das in Figur 1 schematisch angedeutete Gewebe, sondern auch ein Gestrick wie es Figur 2 zeigt. Bei dem Gestrick nach Figur 2 wechseln sich im Gestrick Maschenreihen 21 mit Maschenreihen 22 ab, die abwechselnd aus Glasfaserfäden und Kohlefaserfäden bestehen. Eine weitere Möglichkeit besteht darin beispielsweise zwei Maschenreihen, die unmittelbar aneinander angrenzen, aus Glasfaserfäden herzustellen und jede dritte Maschenreihe aus Kohlefaserfäden.

Bei dem Gestrick wirken die Glasfaserfäden wiederum als Abstandshalter für die Kohlefaserfäden, damit der Lichtdurchtritt durch das Substrat zu der aus der Sicht der Lichtquelle an der Rückseite liegenden Sperrschicht nicht versperrt wird.

Es bedarf keiner weiteren Erläuterung, dass das Gestrick entsprechend dicht hergestellt werden muss und keine "Löcher" in den Maschen enthalten darf, die Fig gibt insoweit die praktische Lösung nicht richtig wieder, weil die Maschen aus Gründen der Darstellung deutlich öffnungen umschließen.

Wenn die Elastizität des Gestricks unerwünscht groß ist, können in den Maschenreihen, wie gezeigt, flott liegende Fäden 23 verwendet werden. Diese flott liegenden Fäden können aus Glasfaserfäden oder aus Kohlefaserfäden bestehen. Wenn die flott liegenden Fäden Kohlefaserfäden sind, können die Maschenreihen ausschließlich aus Glasfaserfäden gestrickt werden, was hinsichtlich der Verstrickbarkeit Vorteile bietet. Zweckmäßigerweise wird als Substrat ein einfaches Rechts-binks-Gestrick verwendet, das besonders dünn hergestellt werden kann.

Eine Solarzelle weist ein Substrat aus einem textilen Flächengebilde auf. Das textile Flächengebilde setzt sich aus lichtdurchlässigen Glasfaserfäden und elektrisch leitenden, jedoch lichtundurchlässigen Kohlefaserfäden zusammen. Die Glasfaserfäden dienen als Abstandshalter und Füller für die Kohlefaserfäden, damit zwischen den Kohlefaserfäden genügend lichtdurchlässige geschlossenen Zwischenräume entstehen, wodurch die Licht durch das Substrat durchtreten kann. Auf beiden Seiten des so gebildeten Substrates befinden sich Halbleiterschichten, die zwischen sich eine Sperrschicht bilden. Die eine Elektrode wird durch die Kohlefaserfäden des Substrates erzeugt.

## Patentansprüche

1. Solarpanel (1)
mit einem zwei Seiten und Seitenränder aufweisenden Substrat (2), das lichtdurchlässig und elektrisch leitend ist,
mit einer ersten dotierten Halbleiterschicht (5), die auf der einen Seite des Substrates (2) angeordnet ist,
mit einer zweiten dotierten Halbleiterschicht (7), die auf der ersten Halbleiterschicht (5) angeordnet ist und mit der ersten Halbleiterschicht (5) einen pn-Übergang bildet,
mit einer dritten dotierten Halbleiterschicht (6), die auf der anderen Seite des Substrates (2) angeordnet ist und die von demselben Leitungstyp ist wie die erste Halbleiterschicht (5),
mit einer vierten dotierten Halbleiterschicht (8), die auf der dritten Halbleiterschicht (6) angeordnet ist und mit der dritten Halbleiterschicht (6) einen pn-Übergang bildet, **dadurch gekennzeichnet, dass**
das Substrat (2) als Gestrick, Gewirk oder Gewebe ausgeführt ist.

2. Solarpanel nach Anspruch 1, **dadurch gekennzeichnet, dass** das Substrat (2) eine Gitterstruktur aufweist.

3. Solarpanel nach Anspruch 1, **dadurch gekennzeichnet, dass** Substrat (2) von einem textilen Flächengebilde gebildet ist.

4. Solarpanel nach Anspruch 1, **dadurch gekennzeichnet, dass** das Substrat (2) Fäden (3) aus lichtdurchlässigem Material aufweist.

5. Solarpanel nach Anspruch 4, **dadurch gekennzeichnet, dass** die Fäden (3) aus lichtdurchlässigem Material Glasfaserfäden sind.

6. Solarpanel nach Anspruch 1, **dadurch gekennzeichnet, dass** das Substrat (2) Fäden (4) aus elektrisch leitendem Material aufweist.

7. Solarpanel nach Anspruch 6, **dadurch gekennzeichnet, dass** das Material für die elektrisch leitenden Fäden (4) aus einer Gruppe ausgewählt ist, die Kohlefasern und Metalle wie Kupfer enthält.

8. Solarpanel nach Anspruch 1, **dadurch gekennzeichnet, dass** das Substrat (2) ein Gewebe in Leinwand- oder Körperbindung ist.

9. Solarpanel nach Anspruch 1, **dadurch gekennzeichnet, dass** das Gewebe (2) Kettfäden (3) aus lichtdurchlässigem Material und Schussfäden (4) aus elektrisch leitendem Material oder umgekehrt aufweist.

10. Solarpanel nach Anspruch 1 , **dadurch gekennzeichnet, dass** das Substrat (2) ein Gestrick oder Gewirke ist, wobei sich Reihen (21, 22) aus lichtdurchlässigem Material und Reihen (21, 22) aus elektrisch leitendem Material abwechseln.

11. Solarpanel nach Anspruch 1, **dadurch gekennzeichnet, dass** auf der jeweils äußeren Halbleiterschicht (7, 8) eine lichtdurchlässige elektrisch leitende Schicht (9, 11) aufgebracht ist, die vorzugsweise aus ZnO besteht.

12. Solarpanel nach Anspruch 1, **dadurch gekennzeichnet, dass** es als äußere Elektrode für die äußere Halbleiterschicht (7, 8) ein Gitter (12, 13) aus elektrisch leitendem Material vorzugsweise Aluminium aufweist.

13. Solarpanel nach Anspruch 1, **dadurch gekennzeichnet, dass** es wenigstens auf einer Seite mit einer Antireflexschicht (14, 15) versehen ist, die vorzugsweise aus Si₃N₄ besteht.

14. Solarpanel nach Anspruch 1, **dadurch gekennzeichnet, dass** es wenigstens auf einer Seite eine Schutzschicht (16, 17) mit Diamantstruktur aufweist.

## Claims

1. A solar panel (1),
including a substrate (2) comprising two sides and side edges, which is translucent and electrically conducting,
including a first doped semiconductor layer (5) arranged on one side of the substrate (2),
including a second doped semiconductor layer (7), which is arranged on the first semiconductor layer (5) and forms a pn junction with the first semiconductor layer (5),
including a third doped semiconductor layer (6), which is arranged on the other side of the substrate (2) and is of the same conductivity type as the first semiconductor layer (5),
including a fourth doped semiconductor layer (8), which is arranged on the third semiconductor layer (6) and forms a pn junction with the third semiconductor layer (6),
**characterized in that**
the substrate (2) is realized as a weft-knitted fabric, a warp-knitted fabric or a woven fabric.

2. The solar panel according to claim 1, **characterized in that** the substrate (2) comprises a grid structure.

3. The solar panel according to claim 1, **characterized in that** the substrate (2) is formed of a textile flat structure.

4. The solar panel according to claim 1, **characterized in that** the substrate (2) comprises filaments (3) of translucent material.

5. The solar panel according to claim 4, **characterized in that** the filaments (3) of translucent material are glass-fiber filaments.

6. The solar panel according to claim 1, **characterized in that** the substrate (2) comprises filaments (4) of an electrically conducting material.

7. The solar panel according to claim 6, **characterized in that** the material for the electrically conducting filaments (4) is selected from a group containing carbon fibers and metals such as copper.

8. The solar panel according to claim 1, **characterized in that** the substrate (2) is a fabric of plain weave or twill weave.

9. The solar panel according to claim 1, **characterized in that** the fabric (2) comprises warp threads (3) of translucent material and weft threads (4) of electrically conducting material, or vice versa.

10. The solar panel according to claim 1, **characterized in that** the substrate (2) is a weft-knitted fabric or a warp-knitted fabric, with rows (21, 22) of translucent material alternating with rows (21, 22) of electrically conducting material.

11. The solar panel according to claim 1, **characterized in that** a translucent, electrically conducting layer (9, 11), preferably made of ZnO, is applied onto the respective outer semiconductor layer (7, 8).

12. The solar panel according to claim 1, **characterized in that** it comprises a grid (12, 13) of electrically conducting material, preferably aluminum, as an outer electrode for the outer semiconductor layer (7, 8).

13. The solar panel according to claim 1, **characterized in that** it is provided, at least on one side, with an anti-reflection layer (14, 15), which is preferably made of Si₃N₄.

14. The solar panel according to claim 1, **characterized in that** it comprises, at least on one side, a protective layer (16, 17) having a diamond structure.

## Revendications

1. Panneau solaire (1)
comprenant un substrat (2) présentant deux côtés et bords de côté, translucide et électriquement conducteur,
comprenant une première couche semi-conductrice dopée (5) qui est disposée d'un côté du substrat (2),
comprenant une deuxième couche semi-conductrice dopée (7) qui est disposée sur la première couche semi-conductrice (5) et constitue une jonction pn avec la première couche semi-conductrice (5),
comprenant une troisième couche semi-conductrice dopée (6) qui est disposée de l'autre côté du substrat (2) et qui est du même type de conductivité que la première couche semi-conductrice (5),
comprenant une quatrième couche semi-conductrice (8) qui est disposée sur la troisième couche semi-conductrice (6) et constitue une jonction pn avec la troisième couche semi-conductrice (6), **caractérisé en ce que**
le substrat (2) est exécuté comme tricot, tissu à mailles ou tissu.

2. Panneau solaire selon la revendication 1, **caractérisé en ce que** le substrat (2) présente une structure de grille.

3. Panneau solaire selon la revendication 1, **caractérisé en ce que** le substrat (2) est constitué par une structure textile plane.

4. Panneau solaire selon la revendication 1, **caractérisé en ce que** le substrat (2) présente des fils (3) en matériau translucide.

5. Panneau solaire selon la revendication 4, **caractérisé en ce que** les fils (3) en matériau translucide sont des fils de fibre de verre.

6. Panneau solaire selon la revendication 1, **caractérisé en ce que** le substrat (2) présente des fils (4) en matériau électriquement conducteur.

7. Panneau solaire selon la revendication 6, **caractérisé en ce que** le matériau pour les fils électriquement conducteurs (4) est sélectionné dans un groupe qui comprend des fibres de carbone et des métaux comme le cuivre.

8. Panneau solaire selon la revendication 1, **caractérisé en ce que** le substrat (2) est un tissu en toile ou en sergé.

9. Panneau solaire selon la revendication 1, **caractérisé en ce que** le tissu (2) présente des fils de chaîne (3) en matériau translucide et des fils de trame (4) en matériau électriquement conducteur ou inversement.

10. Panneau solaire selon la revendication 1, **caractérisé en ce que** le substrat (2) est un tricot ou tissu à mailles, des rangées (21, 22) en matériau translucide et des rangées (21, 22) en matériau électriquement conducteur étant disposées en alternance.

11. Panneau solaire selon la revendication 1, **caractérisé en ce qu'**une couche translucide électriquement conductrice (9, 11) qui se compose de préférence de ZnO est apposée sur la couche semi-conductrice (7, 8) extérieure respective.

12. Panneau solaire selon la revendication 1, **caractérisé en ce qu'**il présente, comme électrode extérieure pour la couche semi-conductrice extérieure (7, 8), une grille (12, 13) en matériau électriquement conducteur, de préférence de l'aluminium.

13. Panneau solaire selon la revendication 1, **caractérisé en ce qu'**il est pourvu, au moins d'un côté, d'une couche antireflet (14, 15) qui se compose de préférence de Si₃N₄.

14. Panneau solaire selon la revendication 1, **caractérisé en ce qu'**il présente, au moins d'un côté, une couche protectrice (16, 17) à structure de diamant.
